# EUROPEAN PATENT APPLICATION

(11) **EP 1 069 213 A2**
(43) Date of publication of application: **17.01.2001**
(21) Application number: 00305851.8
(22) Date of filing: 11.07.2000
(51) Int. Cl.: C25D 5/50

(54) **Optimal anneal technology for micro-voiding control and self-annealing management of electroplated copper**

(30) Priority: 12.07.1999 US 351581
(71) Applicant: Applied Materials, Inc., Santa Clara, California 95054 (US)
(72) Inventor: Cheung, Robin, Cupertino, CA 95014 (US); Chen, Laing-Yuh, Foster City, CA 94404 (US); Neo, Siew, Santa Clara, CA 95051 (US)
(74) Representative: Bayliss, Geoffrey Cyril

(57) **Abstract**

The present invention generally provides for a two step annealing process for a deposited metal layer (18). More particularly, the two step annealing process provides for annealing a metal layer, preferably electroplated copper, at less than about 300°C for less than about 30 seconds, followed by annealing the layer at between about 300°C and about 450°C for less than about 90 seconds. The annealing process occurs in a processing gas preferably with an oxygen content less than about 100 parts per million (ppm) and an hydrogen content less than about 4% by volume. The invention has the advantages of increased substrate throughput rates, improved self-annealing micro-void control, and improved grain growth management.

## Description

The present invention generally relates to deposition of a metal layer onto a substrate. More particularly, the present invention relates to a process for annealing a copper layer deposited on a substrate by an electroplating system.

Consistent and fairly predictable improvement in integrated circuit design and fabrication has been observed in the last decade. One key to successful improvements is the multilevel interconnect technology, which provides the conductive paths between the devices of an integrated circuit (IC) device. The shrinking dimensions of features, presently in the sub-quarter micron and smaller range, such as horizontal interconnects (typically referred to as lines) and vertical interconnects (typically referred to as contacts or vias) in very large scale integration (VLSI) and ultra large scale integration (ULSI) technology, has increased the importance of metal layer deposition and post deposition treatment techniques of metal layers. Contacts extend to a device on the underlying substrate, while vias extend to an underlying metal layer.

The multilevel interconnects that lie at the heart of ultra large scale integration (ULSI) technology require planarization of interconnect features formed in high aspect ratio apertures, including the horizontal and vertical interconnects, and other features. Reliable formation of these interconnects and other features is very important to the success of ULSI and to the continued effort to increase circuit density and quality on individual substrates and die. As circuit densities increase, the widths of the instruments and other features, as well as the dielectric materials between them, decrease to less than 250 nanometers, whereas the thickness of the dielectric layers remains substantially constant, with the result that the aspect ratios for the features, *i.e.*, their height divided by width, increases.

Many traditional deposition processes, such as physical vapor deposition (PVD) and chemical vapor deposition (CVD), have difficulty filling structures where the aspect ratio exceed 4:1, and particularly where it exceeds 10:1. Therefore, there is a great amount of ongoing effort being directed at the formation of void-free, nanometer-sized features having high aspect ratios wherein the ratio of feature height to feature width can be 4:1 or higher. Additionally, as the feature widths decrease, the device current remains constant or increases, which results in an increased current density in the feature.

Elemental aluminum (Al) and its alloys have been the traditional metals used to form lines and plugs in semiconductor processing because of aluminum's perceived low electrical resistivity, its superior adhesion to silicon dioxide (SiO₂), its ease of patterning, and the ability to obtain Al in a highly pure form. However, aluminum has a higher electrical resistivity than other more conductive metals such as copper, and aluminum also can suffer from electromigration leading to the formation of voids in the conductor.

Decreasing feature size has created a need for using a conductive material with greater conductivity than aluminum. Copper and its alloys are now being considered as an interconnect material in place of aluminum, because copper has a lower resistivity (1.7 µΩ-cm compared to 3.1 µΩ-cm for aluminum), significantly higher electromigration resistance, and higher current carrying capacity. These characteristics are important for supporting the higher Current densities experienced at high levels of integration and increase device speed. Copper also has good thermal conductivity and is available in a highly pure form. Therefore, copper is becoming a choice metal for filling sub-quarter micron, high aspect ratio interconnect features on semiconductor substrates.

Despite the desirability of using copper for semiconductor device fabrication, choices of fabrication methods for depositing copper into very high aspect ratio features (e.g. ≥ 4:1 aspect or 0.35µ or less size) are limited. In the past, chemical vapor deposition (CVD) and physical vapor deposition (PVD) were the preferred processes for depositing electrically conductive material, typically aluminum, into the contacts, vias, lines, or other features formed on the substrate. However, for copper applications, precursors for CVD copper processes are being developed, and PVD copper, deposited into such features, has produced unsatisfactory results because of voids formed in the features. For instance, PVD copper tends to bridge the opening to small features resulting in a non-conformal large deposits on the substrate which typically includes voids in the vias and interconnects. As a result of these process limitations, electroplating, which had previously been limited to the circuit board fabrication, is being used to fill vias and contacts on semiconductor devices. Thus, efforts are being explored to improve the electroplating process for use in substrate manufacturing especially in applications with high aspect ratio features.

Metal electroplating is generally known and can be achieved by a variety of techniques. Present designs of cells for electroplating a metal for a substrate are based on a fountain plater configuration. The semiconductor substrate is positioned with the plating surface at a fixed distance above a cylindrical electrolyte container, and the electrolyte impinges perpendicularly on the substrate plating surface. The substrate is the cathode of the plating system, and ions in the plating solution deposit on the conductive, exposed surface of the substrate and in the sub-micron features on the substrate.

A typical copper electroplating deposition method generally comprises physical vapor depositing a barrier layer over the surface of a substrate having various features formed thereon, physical vapor depositing a conductive metal seed layer, preferably copper, over the barrier layer, and then electroplating a conductive metal layer over the seed layer to fill the structure/feature. Finally, the deposited layers and the dielectric layers are planarized, such as by chemical mechanical polishing (CMP), to define a conductive interconnect feature.

Electroplating with copper presents some challenges in substrate manufacturing processes. For instance, electroplated copper does not typically plate evenly across the substrate surface, leaving voids and discontinuities in the features. This unevenness is detrimental to circuit uniformity, conductivity, and reliability. For example, voids form when the copper layer deposits on the substrate so that the copper layer bridges across the opening of a feature before the high aspect ratio is completely filled. Thereafter, the high mobility of metal atoms surrounding the voids causes the atoms to diffuse and minimize the surface area of the voids forming circular shaped voids resulting in poor and unreliable electrical contacts. A void may accumulate and/or grow to a size where the immediate cross-section of the conductor is insufficient to support the quantity of current passing through the conductor, leading to an open circuit. The area of conductor available to conduct heat likewise decreases where the void forms, increasing the risk of conductor failure. The unevenness also affects the adhesion of the conductive material to the substrate and affects the ability of subsequent layers to adequately bond to the conductive material.

To overcome layer unevenness and other process deposition limitations, further heat treatment of a film after deposition is performed. One effective technique is annealing. Annealing is the process of subjecting a material, particularly glass or metal, to heat and then slow cooling. Annealing can be used to flow material to fill voids, purify layers, dope or encourage diffusion of layers, .and manage crystal growth and orientation. Heat introduced during annealing allows the metal layer to flow and fill in voids in high aspect ratios and diffuse into adjacent layers to improve inter-metal adhesion. Additionally, for example, a deposited layer can be annealed in oxygen or nitrogen to form oxides or nitrides with the metal or in an inert atmosphere to remove contaminants. Crystal growth and orientation can be managed by annealing the metal for more than thirty minutes or by briefly melting the metal layer and allowing a cooling time for recrystallization. Annealing also relieves internal stress in the metal layer formed during deposition thereby reducing layer brittleness and increasing layer toughness.

Since copper has a relatively low melting temperature compared to other metals typically deposited in semi-conductor manufacturing, copper is an ideal candidate for annealing. New developments in semiconductor manufacturing that have focused on depositing copper, especially by electroplating techniques, have sparked new interest in developing better copper annealing processes. Additionally, copper deposited by electroplating, or ECP copper, has the physical phenomena of self-annealing. In self-annealing copper will "grow" to a more stable structure after plating at room temperature. Industrial annealing can control this self-annealing process.

Current industry practice is to either perform a higher temperature anneal to achieve grain growth or to perform a low temperature anneal to terminate the self-annealing phenomena. Furnace anneal technology has been primarily used to speed up or control this self-annealing process and to stabilize the film properties for additional down-stream processing steps, such as etching and chemical mechanical polishing. In the annealing furnace, substrates are heated to about 250°C to 400°C, annealed for about 30 minutes, and then cooled to room temperature.

Further, the thickness of the deposited metal layer plays an important role in the final self-anneal state of the copper film. At a typical 250°C furnace anneal or less than 300°C anneal using the Applied Material's (of Santa Clara, California) Electra™ copper plating system, similar stress characteristics and stress reduction will be produced on a blanket film. However, Fine line features, features less than 0.35 µm, that are necessary for advanced applications do not show the stress characteristics and stress reduction of the blanket film for the same process. Therefore fine line features require more energy and require more time to achieve similar stress film results as that of annealed copper layers of large features or blanket films.

As can be expected, the annealing process is time consuming and results in a low substrate throughput rate. Often the throughput rate is four or more hours for a batch of 100 substrates, or approximately the processing rate of less than 25 substrates per hour. This processing rate is undesirably slow for modern semi-conductor manufacturing high production rates.

Therefore there remains a need to develop a more efficient annealing process having a shorter duration for higher substrate throughput and for application to electroplated copper layers. Ideally, the process should address both the grain growth of the copper and the need for copper void-filling in high aspect ratios. Further, the process should overcome the film stress difficulties in fine features.

The present invention generally provides a two step process to anneal a metal layer deposited using electroplating techniques. In one aspect of the invention, the annealing process comprises annealing the metal layer at a first temperature, preferably less than about 300°C for copper, and then annealing the metal layer at a second temperature higher than the first temperature, preferably more than about 300°C and less than about 450°C for copper. Preferably the first temperature anneal has a duration less than about 30 seconds and the second temperature anneal has a duration less than about 90 seconds. The metal is preferably deposited by electroplating at about room temperature and of a material, such as copper, that electroplates readily. The annealing process occurs in a processing gas at approximately atmospheric pressure. Preferably, the processing gas is nitrogen (N₂), argon (Ar), helium (He), and combinations thereof with an oxygen content less than about 100 parts per million (ppm) and an hydrogen content less than about 4% by volume.

In another aspect of the invention, a feature is formed on a substrate by depositing a dielectric layer on the substrate, etching a pattern into the substrate, depositing a barrier layer on the substrate, depositing a conductive metal layer on the barrier layer, annealing the conductive metal layer at a first temperature, and then annealing the conductive metal layer at a second temperature higher than the first temperature as previously described. The two-step anneal process provides for both grain growth control and void filling in high aspect ratios.

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.
Figures 1 is a cross-sectional view of a layered structure with dielectric layer deposited over a substrate and patterned etched to produce a substrate feature in accordance with an embodiment of the present invention.
Figures 2A is a cross-sectional view of a layered structure illustrating deposition and annealing of a copper layer filling the via in accordance with an embodiment of the present invention;
Figures 2B is a cross-sectional view of a layered structure illustrating planarization of the layered structure of Figure 2A;
Figure 3 is a schematic view of an electroplating system platform.
Figure 4 is a cross-sectional view of a rapid thermal anneal chamber.

The present invention generally provides a two step annealing process for deposited metals. More particularly, the present invention provides a two step annealing process for deposited metal layers, such as electroplated copper deposited on substrates, wherein the deposited metal is annealed as a first temperature, and annealed at a second temperature higher than the first temperature. The two step annealing process comprises annealing a metal layer, preferably electroplated copper, at less than about 300°C for less than about 30 seconds, followed by annealing the metal layer at between about 300°C and about 450°C for less than about 90 seconds. The metal is preferably deposited by electroplating at about room temperature. The present invention has the advantages of increased substrate throughput rates, improved self-annealing micro-void control, and improved grain growth management.

The first annealing temperature controls substrate feature micro-voiding by promoting the flow of the annealed material to fill holes and voids formed in apertures and other substrate features. A lower annealing temperature will result in lower stress for the film which acts as the driving force of the self-annealing ECP copper. The second annealing temperature controls the final self-anneal of the metal layer and also manages the grain growth and crystal orientation of the metal film.

Prior annealing processes have not addressed the competing processes of self-annealing micro-voiding control and grain growth management. Typically only one of these concerns is addressed by performing either a high temperature anneal to achieve grain growth or a low temperature anneal to expedite the self-annealing phenomena. Further, the annealing process of the present invention overcomes film stress difficulties in submicron features by allowing, a metal layer with low film stress to develop in the first annealing step, and then, in the second annealing step, by managing grain growth for a more stable metal layer structure while preventing an increase in film stress.

For the annealing process, the annealing chamber is preferably maintained at about atmospheric pressure, and the oxygen content inside the annealing chamber is preferably controlled to less than about 100 parts per million (ppm) during the anneal treatment process. Preferably, the processing gas inside the annealing chamber comprises nitrogen (N₂), argon (Ar), helium (He), and combinations thereof, and comprises less than about 4% hydrogen (H₂). The processing gas flow into the annealing chamber is maintained at greater than 20 liters/min, or the chambers particular needed flow rate, to control the oxygen content to less than 100 ppm.

A skilled practitioner in the art will understand the need to modify the two-step annealing process while retaining the basic nature of the process for performance of the invention with respect to time and temperature and regarding the use of variable equipment, processes, and desired film characteristics.

Copper layers can be effectively improved using this process by depositing the copper layer on the substrate, annealing the copper layer at a first temperature less than about 300°C for less than about 30 seconds to flow the copper layer, and annealing the copper layer at a second temperature between about 300°C and about 450°C for less than about 90 seconds. Copper layers can be deposited by any known method in the art, typically by the commonly known methods of physical vapor deposition (PVD), chemical vapor deposition (CVD), and electroplating. The first anneal allows copper to fill in voids formed in substrate features and to correct other layering defects in the metal layer. The copper flow at a lower temperature reduces film stress developed when the metal layer under goes recrystallization or densification during the annealing process. The higher temperature anneal provides management of grain growth and crystal orientation in the copper layer based upon a stable film structure developed in the low temperature anneal.

To form a substrate feature or aperture in accordance with the present invention, a dielectric layer is formed over a underlying material formed on a substrate. The dielectric layer may be as thick as required for developing any subsequent substrate features such as vertical and horizontal interconnects. The dielectric layer may also be about twice the thickness of a single interconnect layer if a dual damascene via and wire definition are to be patterned etched therethrough. Any dielectric material, whether presently known or yet to be discovered, may be used and is within the scope of the present invention. The dielectric layer may be deposited on any suitable underlying material, but the preferred underlying materials include barrier materials, conductive metals, and doped silicon.

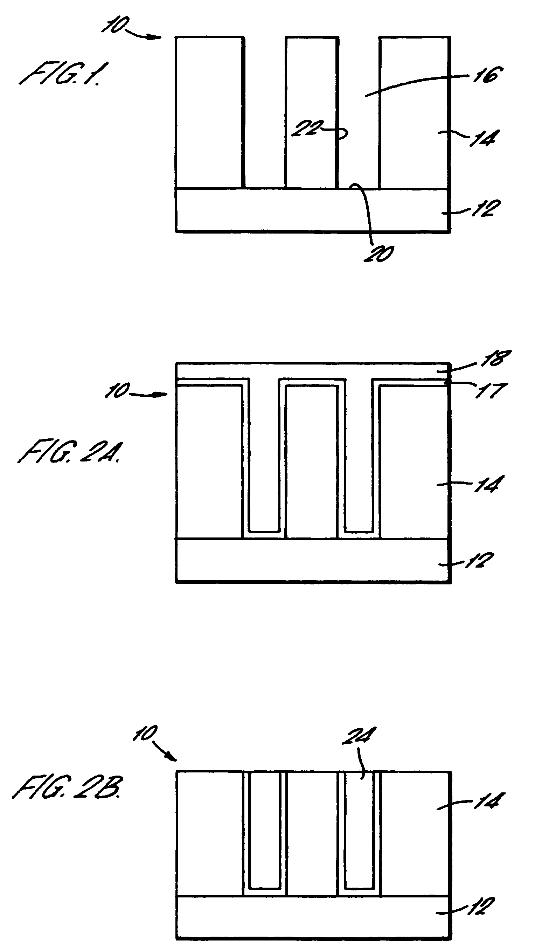

Figure 1 is a cross-sectional diagram of a layered structure 10 showing a dielectric layer 14 formed on a substrate or underlying substrate layer 12, wherein the substrate layer 12 is preferably an electrically conducting member or layer. The substrate layer 12 may take the form of a doped silicon substrate or it may be a first or subsequent conducting layer formed on a substrate. A dielectric layer 14 is formed over the underlying substrate layer 12 in accordance with procedures known in the art to form a part of the overall integrated circuit. Once the dielectric layer 14 is deposited, the dielectric layer 14 is etched to form the desired interconnects 16, wherein the interconnect has a floor 20 exposing a small portion of the underlying substrate layer 12 and dielectric sidewalls 22.

Etching of the dielectric layer 14 may be accomplished with any dielectric etching process, including plasma etching. Specific techniques for etching silicon dioxide and organic materials may include such compounds as buffered hydrofluoric acid and acetone or EKC, respectively. However, patterning and etching may be accomplished using any method known in the art. The underlying material 12 may be a layer, wire or device comprising a metal, doped silicon or other conductive material. In particular, the underlying material may be provided by a barrier layer of common barrier materials such as titanium, titanium nitride, titanium silicon nitride, tungsten nitride, tungsten silicon nitride, tantalum, tantalum nitride, tantalum silicon nitride, doped silicon, aluminum, and aluminum oxides.

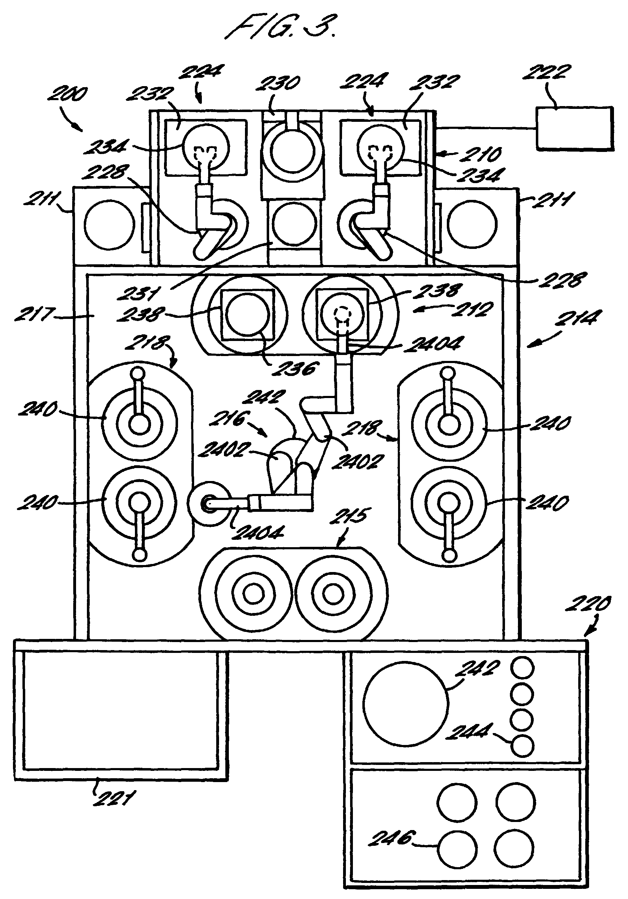

Figure 2A is a cross-sectional diagram of the layered structure 10 of Figure 1 showing a layer of copper 18 preferably deposited by electroplating on a barrier layer 17 that conforms to a patterned dielectric layer 14, the layer of copper 18 completely filling the interconnect 16. In order to fill the interconnect 16, it will generally require that the entire field of the structure will be covered with the electroplated copper. The two step annealing process is then performed by annealing the copper layer 18 at less than about 300°C for less than about 30 seconds, followed by annealing the copper layer 18 at between about 300°C and about 450°C for less than about 90 seconds. Annealing the copper layer will cause the copper to flow and fill any voids (not shown) formed in the vias interconnect 16 and further manage grain growth and crystal orientation of the copper layer 18. The feature may be further processed by planarizing the top portion of the structure 10, as shown in Figure 2B, preferably by chemical mechanical polishing (CMP). During the planarization process, portions of the copper layer 18 and the dielectric layer 14 are removed from the top of the structure leaving a fully planar surface with a conductive feature 24 formed in the via 16 therein.

Alternatively, a seed layer (not shown) may be deposited to help deposition of the electroplated copper layer 18. The seed layer can be copper deposited by physical vapor deposition (PVD) or chemical vapor deposition (CVD); however, any suitable copper seed layer contemplated in the art can be used.

The barrier layer 17 is may deposited prior to a seed layer or the copper layer 18 to prevent diffusion from the copper layer 18 to the underlying substrate layer 12. For copper metal layers, a preferred barrier layer 17 includes such layers as refractory metals (such as tungsten (W), tungsten nitride (WN), niobium (Nb), aluminum silicates, etc.), tantalum (Ta), tantalum nitride (TaN), titanium nitride (TiN), PVD Ti/N₂-stuffed, doped silicon, aluminum, and aluminum oxides, a ternary compound (such as TiSiN, WSiN, etc.) or a combination of these layers. The most preferred barrier materials are Ta and TaN which typically are deposited by PVD.

### The Apparatus

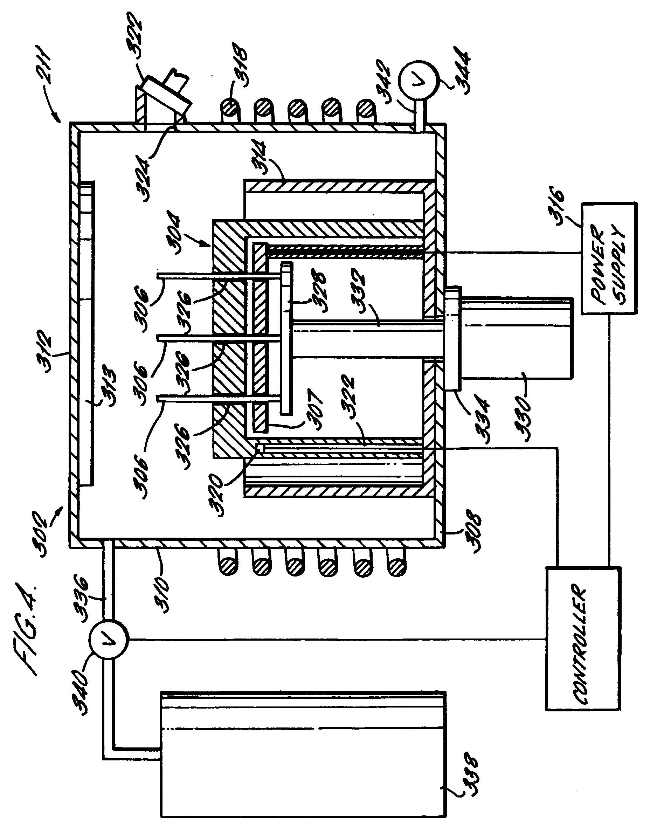

Figure 3 is a schematic view of an electroplating system platform 200 incorporating an annealing chamber 211 suitable for the process of the present invention. Suitable devices generally provide both electroplating deposition, typically copper, and annealing chambers in an integrated process.

The electroplating system platform 200 generally comprises a loading station 210, a thermal anneal chamber 211, a mainframe 214, and an electrolyte replenishing system 220. The mainframe 214 generally comprises a mainframe transfer station 216, a spin-rinse dry (SRD) station 212, a plurality of processing stations 218, and a seed layer repair station 215. Preferably, the electroplating system platform 200, particularly the mainframe 214, is enclosed in a clean environment using panels such as plexiglass panels. The mainframe 214 includes a base 217 having cut-outs to support various stations needed to complete the electro-chemical deposition process. The base 217 is preferably made of aluminum, stainless steel or other rigid materials that can support the various stations disposed thereon. A chemical protection coating, such as Halar™, ethylene-chloro-tri-fluoro-ethaylene (ECTFE), or other protective coatings, is preferably disposed over the surfaces of the base 217 that are exposed to potential chemical corrosion. Preferably, the protective coating provides good conformal coverage over the metal base 217, adheres well to the metal base 217, provides good ductility, and resists cracking under normal operating conditions of the system. Each processing station 218 includes one or more processing cells 240. An electrolyte replenishing system 220 is positioned adjacent the mainframe 214 and connected to the process cells 240 individually to circulate electrolyte used for the electroplating process. The electroplating system platform 200 also includes a power supply station 221 for providing electrical power to the system and a control system 222, typically comprising a programmable microprocessor.

The mainframe transfer station 216 includes a mainframe transfer robot 242 disposed centrally to provide substrate transfer between various stations on the mainframe. Preferably, the mainframe transfer robot 242 comprises a plurality of individual robot arms 2402 that provides independent access of wafers in the processing stations 218 the SRD stations 212, the seed layer repair stations, and other processing stations disposed on or in connection with the mainframe. As shown in Figure 3, the mainframe transfer robot 242 comprises two robot arms 2402, corresponding to the number of processing cells 240 per processing station 218. Each robot arm 2402 includes an end effector 2404 for holding a wafer during a wafer transfer. Preferably, each robot arm 2402 is operable independently of the other arm to facilitate independent transfers of wafers in the system. Alternatively, the robot arms 2402 operate in a linked fashion such that one robot extends as the other robot arm retracts. The mainframe transfer robot 242 includes a plurality of robot arms 2402 (two shown), and a flipper robot 2404 is attached as an end effector for each of the robot arms 2402. Flipper robots are generally known in the art and can be attached as end effectors for wafer handling robots, such as model RR701, available from Rorze Automation, Inc., located in Milpitas, California. The main transfer robot 242 having a flipper robot as the end effector is capable of transferring substrates between different stations attached to the mainframe as well as flipping the substrate being transferred to the desired surface orientation

The loading station 210 preferably includes one or more substrate cassette receiving areas 224, one or more loading station transfer robots 228 and at least one substrate orientor 230. The number of substrate cassette receiving areas, loading station transfer robots 228 and substrate orientor included in the loading station 210 can be configured according to the desired throughput of the system. As shown for one embodiment in Figures 2 and 3, the loading station 210 includes two substrate cassette receiving areas 224, two loading station transfer robots 228 and one substrate orientor 230. A substrate cassette 232 containing substrates 234 is loaded onto the substrate cassette receiving area 224 to introduce substrates 234 into the electroplating system platform. The loading station transfer robot 228 transfers substrates 234 between the substrate cassette 232 and the substrate orientor 230. The loading station transfer robot 228 comprises a typical transfer robot commonly known in the art. The substrate orientor 230 positions each substrate 234 in a desired orientation to ensure that the substrate is properly processed. The loading station transfer robot 228 also transfers substrates 234 between the loading station 210 and the SRD station 212 and between the loading station 210 and the thermal anneal chamber 211. The loading station 210 preferably also includes a substrate cassette 231 for temporary storage of substrates as needed to facilitate efficient transfer of substrates through the system.

Figure 4 is a cross-sectional view of a rapid thermal anneal chamber for use according to the invention. The rapid thermal anneal (RTA) chamber 211 is preferably connected to the loading station 210, and substrates are transferred into and out of the RTA chamber 211 by the loading station transfer robot 228. The electroplating system, preferably comprises two RTA chambers 211 disposed on opposing sides of the loading station 210, corresponding to the symmetric design of the loading station 210. Thermal anneal process chambers are generally well known in the art, and rapid thermal anneal chambers are typically utilized in substrate processing systems to enhance the properties of the deposited materials. The invention contemplates utilizing a variety of thermal anneal chamber designs, including hot plate designs and heat lamp designs, to enhance the electroplating results. One particular thermal anneal chamber useful for the present invention is the WxZ chamber available from Applied Materials, Inc., located in Santa Clara, California. Although the invention is described using a hot plate rapid thermal anneal chamber, the invention contemplates application of other thermal anneal chambers as well.

The RTA chamber 211 generally comprises an enclosure 302, a heater plate 304, a heater 307 and a plurality of substrate support pins 306. The enclosure 302 includes a base 308, a sidewall 310 and a top 312. Preferably, a cold plate 313 is disposed below the top 312 of the enclosure. Alternatively, the cold plate 313 is integrally formed as part of the top 312 of the enclosure. Preferably, a reflector insulator dish 314 is disposed inside the enclosure 302 on the base 308. The reflector insulator dish 314 is typically made from a material such as quartz, alumina, or other material that can withstand high temperatures (*i.e.*, greater than about 500°C), and act as a thermal insulator between the heater 307 and the enclosure 302. The dish 314 may also be coated with a reflective material, such as gold, to direct heat back to the heater plate 306.

The heater plate 304 preferably has a large mass compared to the substrate being processed in the system and is preferably fabricated from a material such as silicon carbide, quartz, or other materials that do not react with any ambient gases in the RTA chamber 211 or with the substrate material. The heater 307 typically comprises a resistive heating element or a conductive/radiant heat source and is disposed between the heated plate 306 and the reflector insulator dish 314. The heater 307 is connected to a power source 316 which supplies the energy needed to heat the heater 307. Preferably, a thermocouple 320 is disposed in a conduit 322, disposed through the base 308 and dish 314, and extends into the heater plate 304. The thermocouple 320 is connected to a controller (*i.e.*, the system controller described below) and supplies temperature measurements to the controller. The controller then increases or decreases the heat supplied by the heater 307 according to the temperature measurements and the desired anneal temperature.

The enclosure 302 preferably includes a cooling member 318 disposed outside of the enclosure 302 in thermal contact with the sidewall 310 to cool the enclosure 302. Alternatively, one or more cooling channels (not shown) are formed within the sidewall 310 to control the temperature of the enclosure 302. The cold plate 313 disposed on the inside surface of the top 312 cools a substrate that is positioned in close proximity to the cold plate 313.

The RTA chamber 211 includes a slit valve 322 disposed on the sidewall 310 of the enclosure 302 for facilitating transfers of substrates into and out of the RTA chamber. The slit valve 322 selectively seals an opening 324 on the sidewall 310 of the enclosure that communicates with the loading station 210. The loading station transfer robot 228 (see Figure 3) transfers substrates into and out of the RTA chamber through the opening 324.

The substrate support pins 306 preferably comprise distally tapered members constructed from quartz, aluminum oxide, silicon carbide, or other high temperature resistant materials. Each substrate support pin 306 is disposed within a tubular conduit 326, preferably made of a heat and oxidation resistant material, that extends through the heater plate 304. The substrate support pins 306 are connected to a lift plate 328 for moving the substrate support pins 306 in a uniform manner. The lift plate 328 is attached to an to an actuator 330, such as a stepper motor, through a lift shaft 332 that moves the lift plate 328 to facilitate positioning of a substrate at various vertical positions within the RTA chamber. The lift shaft 332 extends through the base 308 of the enclosure 302 and is sealed by a sealing flange 334 disposed around the shaft.

To transfer a substrate into the RTA chamber 211, the slit valve 322 is opened, and the loading station transfer robot 228 extends its robot blade having a substrate positioned thereon through the opening 324 into the RTA chamber. The robot blade of the loading station transfer robot 228 positions the substrate in the RTA chamber above the heater plate 304, and the substrate support pins 306 are extended upwards to lift the substrate above the robot blade. The robot blade then retracts out of the RTA chamber, and the slit valve 322 closes the opening. The substrate support pins 306 are then retracted to lower the substrate to a desired distance from the heater plate 304. Optionally, the substrate support pins 306 may retract fully to place the substrate in direct contact with the heater plate.

Preferably, a gas inlet 336 is disposed through the sidewall 310 of the enclosure 302 to allow selected gas flow into the RTA chamber 211 during the anneal treatment process. The gas inlet 336 is connected to a gas source 338 through a valve 340 for controlling the flow of the gas into the RTA chamber 211. A gas outlet 342 is preferably disposed at a lower portion of the sidewall 310 of the enclosure 302 to exhaust the gases in the RTA chamber and is preferably connected to a relief/check valve 344 to prevent backstreaming of atmosphere from outside of the chamber. Optionally, the gas outlet 342 is connected to a vacuum pump (not shown) to exhaust the RTA chamber to a desired vacuum level during an anneal treatment.

According to the invention, a substrate is annealed in the RTA chamber 211 after the substrate has been electroplated in the electroplating cell and cleaned in the SRD station. Preferably, the RTA chamber 211 is maintained at about atmospheric pressure, and the oxygen content inside the RTA chamber 211 is controlled to less than about 100 ppm during the anneal treatment process. Preferably, the process gas inside the RTA chamber 211 comprises nitrogen (N₂), argon (Ar), helium (He), and combinations thereof, with less than about 4% hydrogen (H₂), and the process gas flow into the RTA chamber 211 is maintained at greater than 20 liters/min to control the oxygen content to less than 100 ppm.

The electroplated substrate is preferably annealed at a temperature less than 300°C for less than 30 seconds, followed by annealing the layer at between 300°C and 450°C for less than 90 seconds. Rapid thermal anneal processing typically requires a temperature increase of at least 50°C per second. To provide the required rate of temperature increase for the substrate during the anneal treatment, the heater plate is preferably maintained at between about 350°C and about 450°C, and the substrate is preferably positioned at between about 0 mm (*i.e.*, contacting the heater plate) and about 20 mm from the heater plate for the duration of the anneal treatment process. Preferably, a control system 222 controls the operation of the RTA chamber 211, including maintaining the desired ambient environment in the RTA chamber and the temperature of the heater plate.

After the anneal treatment process is completed, the substrate support pins 306 lift the substrate to a position for transfer out of the RTA chamber 211. The slit valve 322 opens, and the robot blade of the loading station transfer robot 228 is extended into the RTA chamber and positioned below the substrate. The substrate support pins 306 retract to lower the substrate onto the robot blade, and the robot blade then retracts out of the RTA chamber. The loading station transfer robot 228 then transfers the processed substrate into the cassette 232 for removal out of the electroplating processing system. (see Figure 3).

Referring back to Figure 3, the electroplating system platform 200 includes a control system 222 that controls the functions of each component of the platform. Preferably, the control system 222 is mounted above the mainframe 214 and comprises a programmable microprocessor. The programmable microprocessor is typically programmed using a software designed specifically for controlling all components of the electroplating system platform 200. The control system 222 also provides electrical power to the components of the system and includes a control panel (not shown) that allows an operator to monitor and operate the electroplating system platform 200. The control panel is a stand-alone module that is connected to the control system 222 through a cable and provides easy access to an operator. Generally, the control system 222 coordinates the operations of the loading station 210, the RTA chamber 211, the SRD station 212, the mainframe 214 and the processing stations 218. Additionally, the control system 222 coordinates with the controller of the electrolyte replenishing system 220 to provide the electrolyte for the electroplating process.

The following is a description of a typical substrate electroplating process sequence through the electroplating system platform 200 as shown in Figure 3. A substrate cassette containing a plurality of substrates is loaded into the substrate cassette receiving areas 224 in the loading station 210 of the electroplating system platform 200. A loading station transfer robot 228 picks up a substrate from a substrate slot in the substrate cassette and places the substrate in the substrate orientor 230. The substrate orientor 230 determines and orients the substrate to a desired orientation for processing through the system. The loading station transfer robot 228 then transfers the oriented substrate from the substrate orientor 230 and positions the substrate in one of the substrate slots in the substrate pass-through cassette 238 in the SRD station 212. The mainframe transfer robot 216 picks up the substrate from the substrate pass-through cassette 238 and positions the substrate for transfer to one of the connected repair process cells 215 for a seed layer repair process utilizing electroless deposition. After the seed layer repair process, the mainframe transfer robot 216 transfers the substrate to the processing cell 240 for the electroplating process Typically, the electroplating is carried out at room temperature, but may vary as necessary to incorporate new electroplating processes.

After the electroplating deposition process is completed, the mainframe transfer robot 216 then transfers and positions the processed substrate above the SRD module 236. The SRD substrate support lifts the substrate, and the mainframe transfer robot blade retracts away from the SRD module 236. The substrate is cleaned in the SRD module using deionized water or a combination of deionized water and a cleaning fluid as described in detail above. The substrate is then positioned for transfer out of the SRD module. The loading station transfer robot 228 picks up the substrate from the SRD module 236 and transfers the processed substrate into the RTA chamber 211 for an anneal treatment process to enhance the properties of the deposited materials. The annealed substrate is then transferred out of the RTA chamber 211 by the loading station robot 228 and placed back into the substrate cassette for removal from the electroplating system. The above-described sequence can be carried out for a plurality of substrates substantially simultaneously in the electroplating system platform 200 of the present invention. Also, the electroplating system according to the invention can be adapted to provide multi-stack substrate processing.

While foregoing is directed to the preferred embodiment of the present invention, other and further embodiments of the invention may be devised without departing from the basic scope thereof, and the scope thereof is determined by the claims that follow.

## Claims

1. An annealing process for a metal layer comprising:
a) annealing the metal layer at a first temperature; and
b) annealing the metal layer at a second temperature higher than the first temperature.

2. A process as claimed in claim 1, wherein the first temperature is less than about 300°C.

3. A process as claimed in claim 1 or claim 2, wherein the second temperature is more than about 300°C and less than about 450°C.

4. A process as claimed in any of claims 1 to 3, wherein the metal layer is amended at the first temperature for less than about 30 seconds.

5. A process as claimed in any of claims 1 to 4, wherein the metal layer is annealed at the second temperature for less than about 90 seconds.

6. A process as claimed in any of claims 1 to 5, wherein the metal layer is copper.

7. A process as claimed in any of claims 1 to 6, wherein the metal layer is deposited by electroplating.

8. A process as claimed in any of claims 1 to 7, wherein the metal layer is annealed in a processing gas selected from the group consisting of nitrogen (N₂), argon (Ar), helium (He), and combination thereof.

9. A process as claimed in claim 8, wherein the procesing gas has an oxygen content less than about 100 parts per million (ppm).

10. A process as claimed in claim 9, wherein the processing gas has an hydrogen content less than about 4% by volume.

11. A process of forming a copper layer on a substrate, comprising:
a) depositing the copper layer on the substrate;
b) annealing the copper layer at a first temperature less than about 300°C for less than about 30 seconds; and
c) annealing the copper layer at a second temperature greater than about 300°C for less than about 90 seconds.

12. A process as claimed in claim 11, wherein the copper layer is deposited by electroplating.

13. A process as claimed in claim 11 or claim 12, wherein the second temperature is less than about 450°C.

14. A process as claimed in any of claims 11 to 13, wherein the copper layer is annealed in a processing gas selected from the group consisting of nitrogen (N₂), argon (Ar), helium (He), and combinations thereof.

15. A process as claimed in claim 14, wherein c has an oxygen content less than about 100 parts per million (ppm).

16. A process as claimed in claim 15, wherein the metal layer is annealed in a processing gas that has an hydrogen content less than about 4% by volume.

17. A process for forming a feature on a substrate comprising:
a) depositing a dielectric layer on the substrate;
b) etching an aperture within the dielectric layer;
c) depositing a conductive metal layer in the barrier layer;
d) annealing the conductive metal layer at a first temperature; and
e) annealing the conductive metal layer at a second temperature higher than the first temperature.

18. A process as claimed in claim 17, further comprising planarizing the conductive metal and dielectric layers.

19. A process as claimed in claim 17 or claim 18, wherein the first temperature is less than about 300°C and the second temperature is more than about 300°C and less than about 450°C.

20. A process as claimed in any of claims 17 to 19, wherein the conductive metal layer is annealed at the first temperature for less than about 30 seconds and is annealed at the second temperature for less than about 90 seconds.

21. A process as claimed in any of claims 17 to 20, wherein the conductive metal layer is copper.

22. A process as claimed in any of claims 17 to 21, wherein the conductive metal layer is deposited by electroplating.

23. A process as claimed in any of claims 17 to 22, wherein the conductive metal layer is annealed in a processing gas selected from the group consisting of nitrogen (N₂), argon (Ar), helium (He), and combinations thereof.

24. A process as claimed in claim 23, wherein the processing gas has an oxygen content less than about 100 parts per million (ppm).

25. A process as claimed in claim 24, wherein the processing gas has an hydrogen content less than about 4% by volume.
